# FASCICULE DE BREVET EUROPEEN

(11) **EP 2 727 178 B1**
(45) Date de publication et mention de la délivrance du brevet: **09.11.2016**
(21) Numéro de dépôt: 12743472.8
(22) Date de dépôt: 28.06.2012
(51) Int. Cl.: H01M 6/40, H01M 10/04, H01M 10/42, H01M 10/0565, H01M 10/0525, H01M 10/0585, H01M 2/26, H01M 10/48

(54) **PROCÉDÉ DE RÉALISATION D'UN DISPOSITIF À BATTERIES AVEC TEST DU FONCTIONNEMENT DES BATTERIES AVANT DE LES RELIER ÉLECTRIQUEMENT.**
VERFAHREN ZUR HERSTELLUNG EINER BATTERIENVORRICHTUNG MIT PRÜFUNG DES BETRIEBS DER BATTERIEN VOR IHREM ELEKTRISCHEN ANSCHLUSS
METHOD OF PRODUCING A DEVICE HAVING BATTERIES WITH TESTING OF THE OPERATION OF THE BATTERIES BEFORE CONNECTING THEM ELECTRICALLY

(30) Priorité: 01.07.2011 FR 1102080
(43) Date de publication de la demande: 07.05.2014
(73) Titulaire: Commissariat à l'Énergie Atomique et aux Énergies Alternatives, 75015 Paris (FR)
(72) Inventeur: SALOT Raphaël, F- 38250 Lans-en-Vercors (FR); ACHATZ Philipp, F-38000 Grenoble (FR); MARTIN Steve, F- 38160 Saint-Sauveur (FR); OUKASSI Sami, F-38120 Saint-Egrève (FR)
(74) Mandataire: Talbot, Alexandre
(86) Numéro de dépôt international: PCT/FR2012/000260
(87) Numéro de publication internationale: WO 2013/004922

(56) Documents cités:
- WO-A2-2008/004161
- US-A1- 2005 233 210
- US-A1- 2008 003 493
- ALAHMAD ET AL: "Battery switch array system with application for JPL's rechargeable micro-scale batteries", JOURNAL OF POWER SOURCES, ELSEVIER SA, CH, vol. 177, no. 2, 23 novembre 2007 (2007-11-23), pages 566-578, XP022450305, ISSN: 0378-7753, DOI: 10.1016/J.JPOWSOUR.2007.11.053

## Description

### Domaine technique de l'invention

L'invention est relative à un procédé de réalisation d'un dispositif à batteries.

### État de la technique

Les dispositifs à batteries comportent en règle générale des batteries agencées sous forme de matrices sur un substrat de support. Toutes les batteries sont reliées électriquement en parallèle pour former un circuit optimisant la capacité de stockage d'énergie du dispositif tout en conservant une même tension. Lors du branchement de batteries en parallèle, il suffit que l'une des batteries soit défectueuse pour que l'ensemble de la matrice subisse une perte drastique de rendement, voire devienne elle-même défectueuse.

Ainsi, lors de la fabrication d'une matrice de batteries, les différentes batteries sont formées sur un substrat puis elles sont testées individuellement. Les batteries fonctionnelles sont alors désolidarisées du substrat pour être collées sur un nouveau substrat où elles seront reliées électriquement en parallèle.

Ce procédé est coûteux à mettre en oeuvre car il nécessite de nombreuses étapes. De plus, il suffit que l'une des batteries soit abîmée lors des opérations de séparation consécutives au test pour rendre non fonctionnel le dispositif à batteries, dès lors les rendements de fabrication sont relativement faibles.

Le document WO2008/004161 décrit par exemple un tel procédé.

### Objet de l'invention

L'objet de l'invention consiste à réaliser un dispositif à batteries facile à mettre en oeuvre pour diminuer les coûts de fabrication et augmenter les rendements d'un tel dispositif, en particulier sur de grandes surfaces.

On tend vers cet objet par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 illustre une vue en coupe de la réalisation d'une étape du procédé consistant à déposer une couche électriquement conductrice sur un substrat,
La figure 2 illustre une vue en coupe d'une étape de formation d'une pluralité de batteries,
La figure 3 illustre une vue de dessus de la figure 2,
La figure 4 illustre une vue en coupe de l'étape de test électrique des batteries pour différencier les batteries fonctionnelles des batteries défectueuses,
La figure 5 illustre une vue en coupe obtenue après l'étape dans laquelle les batteries fonctionnelles sont reliées en parallèle,
Les figures 6 à 9 illustrent un premier mode de réalisation permettant de relier électriquement en parallèle les batteries fonctionnelles,
La figure 10 illustre un second mode de réalisation permettant de relier électriquement en parallèle les batteries fonctionnelles,
La figure 11 illustre un troisième mode de réalisation,
La figure 12 illustre une variante de réalisation du troisième mode de réalisation.

### Description de modes préférentiels de réalisation

Le procédé, et ses variantes, illustre la réalisation d'un dispositif à batteries dont les étapes permettent l'obtention d'un rendement optimal tout en garantissant une facilité de mise en oeuvre.

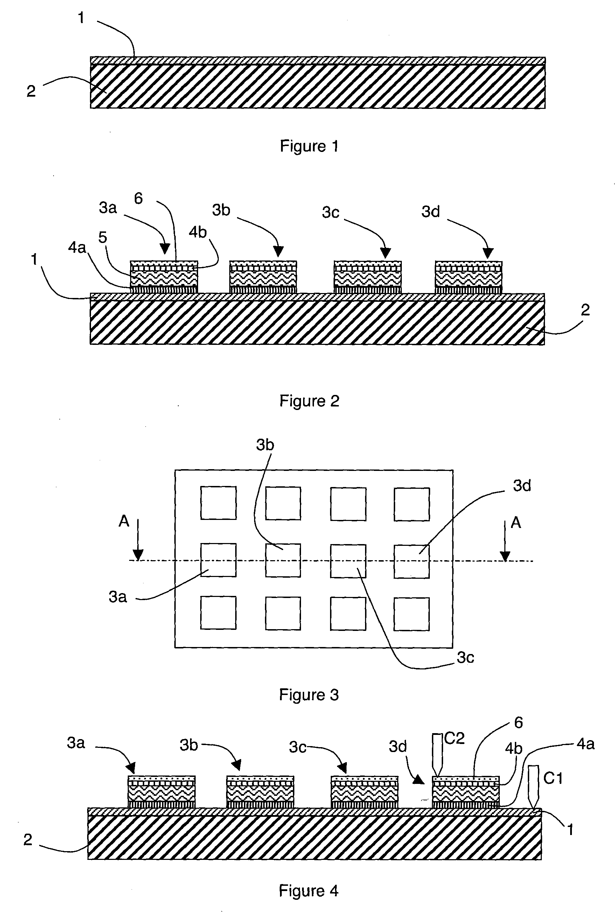

Sur la figure 1, le procédé comporte une première étape dans laquelle une première couche électriquement conductrice 1 est déposée sur un substrat de support 2 de manière à obtenir un substrat de support 2 comportant une première couche électriquement conductrice 1 formant une face principale.

La première couche électriquement conductrice 1 est destinée à former par la suite, au moins en partie, un premier collecteur de courant du dispositif à batteries.

Sur la figure 2, à la suite de l'étape de dépôt de la première couche électriquement conductrice 1 sur le substrat de support 2, une pluralité de batteries 3a, 3b, 3c, 3d est formée sur la première couche électriquement conductrice 1. Préférentiellement, la couche électriquement conductrice 1 relie électriquement la pluralité de batteries 3a, 3b, 3c, 3d. Les batteries 3a, 3b, 3c, 3d sont situées dans un même plan parallèle au substrat de support 2.

Chaque batterie 3a, 3b, 3c, 3d peut comporter un empilement réalisé sur la première couche électriquement conductrice 1. Un empilement peut comprendre une première électrode 4a, une membrane électrolytique 5, une seconde électrode 4b, la première électrode 4a étant en contact électrique avec la première couche électriquement conductrice 1. Autrement dit, la membrane 5, et la seconde électrode 4b sont disposées successivement au-dessus de la première électrode 4a dans une direction opposée au substrat de support 2.

Avantageusement, l'étape de formation des batteries 3a, 3b, 3c, 3d est réalisée de manière simultanée sur ledit substrat de support 2. Autrement dit, toutes les batteries 3a, 3b, 3c, 3d sont obtenues après dépôt et structuration, ou dépôt sélectif avec utilisation de masques appropriés, de couches aptes à former les empilements. Ceci peut être réalisé en utilisant les technologies monolithiques. L'avantage particulier d'une telle réalisation est d'assurer que les batteries soient identiques. En effet, une autre problématique liée à la mise en parallèle de batteries est que ces dernières sont préférentiellement identiques, et proviennent de mêmes lots de fabrication pour assurer un fonctionnement optimal du dispositif final. Dans le cas présent, les batteries étant issues du dépôt de mêmes couches, on est assuré d'avoir des batteries identiques, ce qui a pour conséquence d'augmenter les rendements et la qualité des dispositifs à batteries fabriqués.

La figure 3 illustre une vue de dessus du dispositif à batteries après formation des empilements, on y retrouve les batteries 3a, 3b, 3c, 3d de la figure 2 qui est une vue en coupe selon A-A de la figure 3. Avantageusement, afin d'optimiser le nombre de batteries sur un même support, ces dernières sont formées sous la forme d'une matrice de sorte à être alignées en lignes et colonnes.

Comme illustré à la figure 4, après avoir formé la pluralité de batteries 3a, 3b, 3c, 3d, le procédé comporte une étape dans laquelle le fonctionnement des batteries est testé. Ces tests ont pour but de déterminer les batteries fonctionnelles et la, ou les, batterie(s) éventuellement défectueuse(s), autrement dit ce test a pour but de discriminer un premier groupe de batteries fonctionnelles 3a, 3b, 3d et un deuxième groupe de batteries défectueuses 3c. Cette étape de test est préférablement réalisée en prenant, pour chaque batterie 3a, 3b, 3c, 3d, un premier contact électrique C1 sur la première couche électriquement conductrice 1, et un second contact C2 électrique associé à la seconde électrode 4b de la batterie 3d concernée pour réaliser un test électrique de ladite batterie 3d. Comme sur la figure 4, les contacts C1 et C2 peuvent se présenter sous la forme de pointes communément utilisés dans la microélectronique pour tester les circuits. Le test électrique peut être réalisé par mesure de la résistance interne de la batterie 3d, par mesure du courant traversant la batterie 3d en circuit ouvert (OCV pour « Open Circuit Voltage » en anglais), par méthode EIS (pour « Electrochemical Impedance Spectroscopy » en anglais ou spectroscopie d'impédance électrochimique en français). De tels tests permettent de réaliser des mesures rapides et non destructives pour l'empilement. Outre les tests électriques, il est aussi possible de vérifier les batteries par thermographie infrarouge optique, AFM (microscopie à force atomique), FTIR (spectroscopie infrarouge à transformée de Fourier), XPS (spectroscopie de photoélectrons induits par rayons X), selon ces tests si une batterie n'a pas des caractéristiques suffisantes de qualité, elle sera rejetée et considérée comme défectueuse.

Une batterie peut être considérée comme défectueuse dès qu'elle ne répond plus au cahier des charges, par exemple un seuil de tension, un seuil de courant, un temps de recharge, etc.

Lors du test, le premier contact C1 peut être un contact permanent, c'est-à-dire que ce contact C1 sera utilisé pour tester toutes les batteries sans déplacer ledit premier contact C1 entre deux tests de batteries distinctes. Ceci est rendu possible par le fait qu'au moment des tests la première couche électriquement conductrice 1 est, préférentiellement, en contact électrique avec les premières électrodes 4a de toutes les batteries 3a, 3b, 3c, 3d. Le second contact C2 pourra quant à lui être déplacé de batterie en batterie pour être associé à la seconde électrode 4b correspondante.

Par « associé à la seconde électrode 4b », on entend que lors d'un test il est possible de mettre en contact direct le second contact C2 avec la seconde électrode 4b, ou avec une couche intermédiaire 6 électriquement conductrice de la batterie disposée au sommet de l'empilement opposé au substrat de support 2 (figures 2 et 4). Cette couche intermédiaire 6 peut être en contact direct avec la seconde électrode 4b. La couche intermédiaire 6 permet deux fonctions, la protection de l'empilement, et l'amélioration des contacts électriques pour faciliter les tests électriques, cette couche 6 sera préférentiellement réalisée en titane, nickel, platine, ou autres matériaux idoines. En fait pour effectuer le test, il suffit d'avoir une continuité électrique entre le premier contact C1 et la première électrode 4a, et entre le second contact C2 et la seconde électrode 4b.

Après avoir testé toutes les batteries, il est aisé de dessiner une cartographie des batteries défectueuses et/ou fonctionnelles qui pourra être utilisée pour établir un futur circuit du dispositif à batteries.

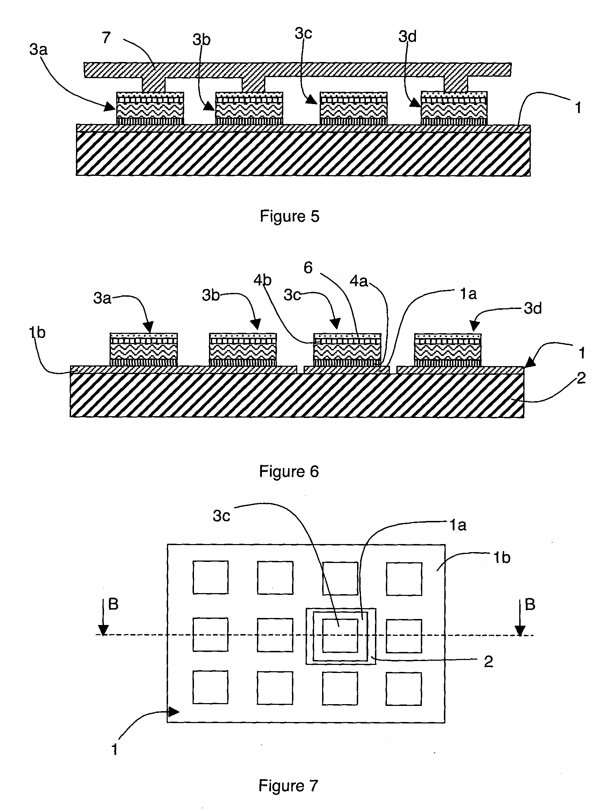

Comme illustré à la figure 5, une seconde couche électriquement conductrice 7, isolée électriquement de la première couche électriquement conductrice 1, est déposée, après le test des batteries, afin de former un circuit dans lequel uniquement les batteries fonctionnelles sont connectées en parallèle, la ou les éventuelle(s) batterie(s) défectueuse(s) étant alors hors du circuit. La première couche électriquement conductrice 1 et la seconde couche électriquement conductrice 7 sont configurées pour connecter en parallèle uniquement les batteries fonctionnelles 3a, 3b et 3c. Le seconde couche électriquement conductrice 7 forme alors au moins en partie un second collecteur de courant du dispositif à batteries, le branchement en parallèle étant alors réalisé entre les premier et second collecteurs de courant.

La capacité, ainsi que la puissance maximale du dispositif à batteries obtenu sera fonction du taux de remplissage de la surface disponible du substrat de support et du nombre de batteries défectueuses.

Dans l'exemple particulier de la figure 5, les batteries 3a, 3b et 3d sont fonctionnelles et la batterie 3c est défectueuse. Les première et seconde couches électriquement conductrices 1, 7 forment des collecteurs de courant connectant en parallèle les batteries fonctionnelles. La batterie défectueuse 3c est reliée électriquement uniquement à un des collecteurs de courant (couche 7), elle n'est donc pas incluse dans le circuit en parallèle des batteries fonctionnelles.

La formation du circuit de batteries fonctionnelles mises en parallèle peut être mise en oeuvre selon différents modes de réalisation.

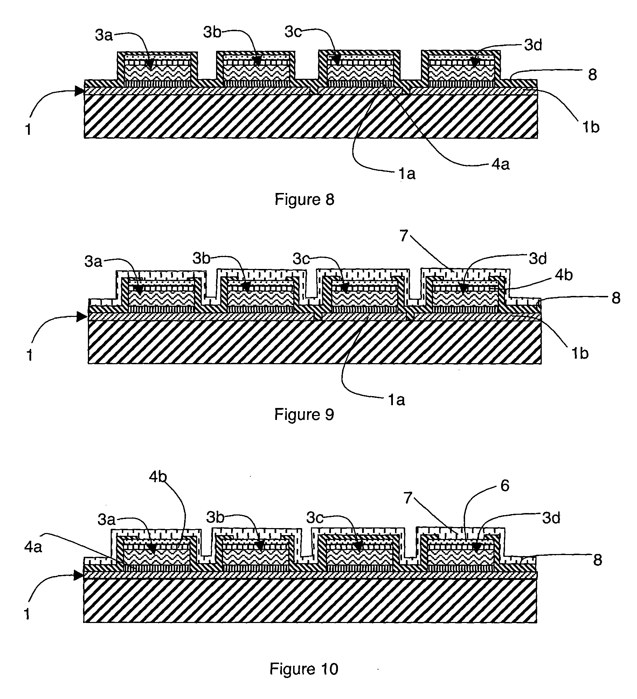

Dans un premier mode illustré aux figures 6 à 9, une portion 1 a de la première couche électriquement conductrice 1 portant une batterie défectueuse 3c est isolée électriquement d'une autre portion 1 b de la première couche électriquement conductrice 1 commune aux batteries fonctionnelles 3a, 3b, 3d comme illustré aux figures 6 et 7, la figure 7 étant une vue de dessus de la figure 6 associée à la coupe B-B. En fait, la portion 1 a correspond au moins, préférentiellement, à une portion de la première couche électriquement conductrice en contact électrique avec la première électrode 4a de la batterie défectueuse. Les dimensions de cette portion 1 a sont aux moins égales aux dimensions de la batterie défectueuse portée de sorte à isoler électriquement la batterie défectueuse de la portion 1 b commune aux batteries fonctionnelles. Cette étape d'isolation d'une batterie défectueuse peut être réalisée avant l'étape de dépôt de la seconde couche électriquement conductrice 7, la première couche 1 étant alors encore accessible entre deux batteries adjacentes. De préférence, toutes les batteries défectueuses sont isolées de cette manière avant le dépôt de la seconde couche électriquement conductrice 7. Par exemple, l'isolation d'une batterie défectueuse 3c est réalisée par gravure de la première couche électriquement conductrice 1 jusqu'au substrat de support 2 (figure 6 et 7). La gravure peut être réalisée par toute méthode idoine connue de l'homme du métier. Préférentiellement, on utilisera une technique de gravure par laser qui est une méthode souple et configurable à la demande. En fonction de la cartographie des batteries fonctionnelles et/ou défectueuses la gravure laser sera réitérée au niveau de chaque batterie défectueuse. Après isolation des batteries défectueuses, la seconde couche électriquement conductrice 7 peut alors être déposée de sorte à connecter électriquement toutes les batteries au niveau des secondes électrodes 4b. Par « au niveau des secondes électrodes » on entend que la continuité électrique est réalisée entre les secondes électrodes 4b et la seconde couche électriquement conductrice 7, que cela soit par contact direct ou avec interposition d'une couche électriquement conductrice comme la couche intermédiaire 6 évoquée ci-dessus. Autrement dit, la mise hors du circuit d'une batterie défectueuse 3c est réalisée par l'isolement de la portion 1 a de première couche électriquement conductrice portant ladite batterie défectueuse de la portion 1 b de première couche électriquement conductrice associée aux batteries fonctionnelles. En fait sur la figure 9, la seconde couche électriquement conductrice 7 est en continuité électrique avec toutes les secondes électrodes 4b des batteries, uniquement la portion 1 b commune à toutes les batteries fonctionnelles permet de relier électriquement en parallèle toutes les batteries fonctionnelles.

Dans ce premier mode de réalisation, l'isolation électrique entre la première couche électriquement conductrice 1 et la seconde couche électriquement conductrice 7 peut être réalisée par interposition d'une couche électriquement isolante 8. Ainsi, comme illustré à la figure 8, après isolement de toutes les batteries défectueuses 3c, une couche électriquement isolante 8 est déposée (figure 8) sur les batteries et entre les batteries, préférentiellement par dépôt conforme. Cette couche électriquement isolante 8 est ensuite structurée de sorte à laisser accessibles toutes les batteries 3a, 3b, 3c, 3d au niveau des secondes électrodes 4b (figure 9). Les ouvertures générées par la structuration permettent de déposer la seconde couche électriquement conductrice 7 (figure 9) en mettant ladite seconde couche électriquement conductrice 7 en continuité électrique avec toutes les secondes électrodes (contact direct ou avec interposition de la couche intermédiaire 6). La couche électriquement isolante 8 peut être de type diélectrique.

Dans le premier mode de réalisation, le premier collecteur de courant est formé par la portion 1 b de la première couche électriquement conductrice commune aux batteries fonctionnelles et le second collecteur de courant est formé par la seconde couche électriquement conductrice 7.

Selon un deuxième mode de réalisation illustré à la figure 10, la seconde couche électriquement conductrice 7 est déposée après une couche électriquement isolante 8, ladite couche électriquement isolante 8 recouvrant lesdites batteries. Avant dépôt de la seconde couche électriquement conductrice 7 la couche électriquement isolante 8 est ouverte localement en plusieurs endroits pour laisser accessible uniquement les batteries fonctionnelles 3a, 3b, 3d de sorte que ladite seconde couche électriquement conductrice 7 connecte électriquement, après son dépôt, uniquement les batteries fonctionnelles au niveau des ouvertures localisées de la couche électriquement isolante 8. Les batteries fonctionnelles 3a, 3b, 3d sont connectées à travers la couche électriquement isolante 8. Une ouverture peut être réalisée par ablation locale de la couche électriquement isolante 8 par laser. Ce mode de réalisation est préféré au premier mode de réalisation car les zones de matériau à retirer sont de plus faibles surfaces. Ceci permet donc une augmentation de la vitesse de fabrication, une simple ouverture étant suffisante alors que dans le premier mode de réalisation il faut ablater la première couche électriquement conductrice 1 tout autour de la batterie défectueuse.

Dans ce second mode de réalisation, la première couche électriquement conductrice 1 est, préférentiellement, en contact électrique avec toutes les premières électrodes 4a des batteries, et la seconde couche électriquement conductrice 7 est en contact électrique uniquement avec les secondes électrodes 4b des batteries fonctionnelles 3a, 3b, 3d, la batterie 3c étant alors hors du circuit. Le contact électrique entre la seconde couche électriquement conductrice 7 et une électrode 4b peut être direct ou par interposition d'une couche intermédiaire 6 telle que visée ci-dessus.

Dans le second mode de réalisation, le premier collecteur de courant est formé par la première couche électriquement conductrice 1 et le second collecteur de courant est formé par la seconde couche électriquement conductrice 7.

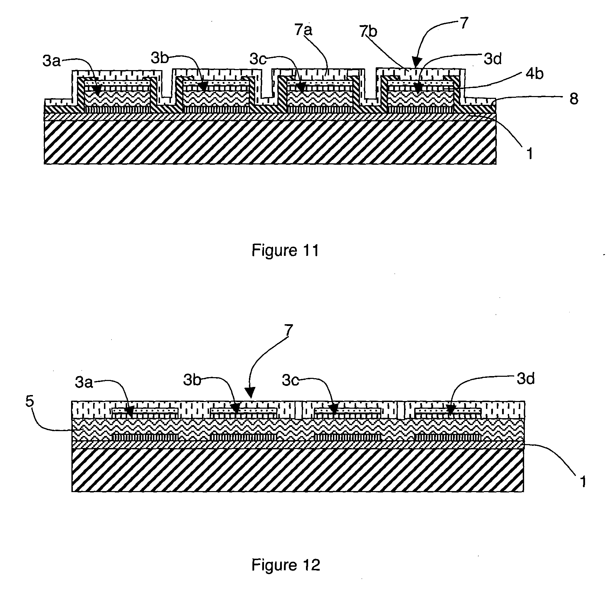

Selon un troisième mode de réalisation illustré à la figure 11, la seconde couche électriquement conductrice 7 est déposée de sorte à être connectée électriquement avec toutes les batteries 3a, 3b, 3c, 3d. Ensuite, la seconde couche électriquement conductrice 7 est structurée pour isoler électriquement une portion 7a de la seconde couche électriquement conductrice associée à une batterie défectueuse d'une autre portion 7b de la seconde couche électriquement conductrice commune aux batteries fonctionnelles (les batteries fonctionnelles ont alors leurs secondes électrodes 4b électriquement reliées à la portion 7b commune). Cette structuration peut être réalisée pour toutes les batteries défectueuses, par exemple de la même manière qu'évoquée précédemment pour le mode de réalisation où la première couche électriquement conductrice est structurée en portions. Préférentiellement, la portion 7a associée à une batterie défectueuse correspond à une portion de la seconde couche électriquement conductrice 7 qui est en continuité électrique avec la seconde électrode de la batterie défectueuse, les dimensions de ladite portion 7a étant au moins définies par la surface de la seconde couche électriquement conductrice 7 à l'interface avec la batterie défectueuse de sorte à éviter le contact électrique entre la batterie défectueuse 3c et la portion 7b commune aux batteries fonctionnelles.

De manière applicable aux premier et troisième modes de réalisation, lorsque des batteries adjacentes sont défectueuses, l'ablation de la couche électriquement conductrice associée permettant leurs isolation pourra être réalisée de sorte qu'une même portion, distincte de la portion commune aux batteries fonctionnelles, soit associée à plusieurs batteries défectueuses, ceci permet de limiter l'enlèvement de matière au niveau de la couche électriquement conductrice concernée, et donc d'augmenter le cadencement de fabrication des dispositifs.

Dans le troisième mode de réalisation, le second collecteur de courant est formé par la portion 7b de la seconde couche électriquement conductrice 7 commune aux batteries fonctionnelles et le second collecteur de courant est formé par la première couche électriquement conductrice 1.

Dans une variante du troisième mode de réalisation illustrée à la figure 12, l'étape de formation de la pluralité de batteries 3a, 3b, 3c, 3d comporte, préférentiellement, le dépôt d'une membrane électrolytique 5 commune à toutes les batteries, ladite membrane électrolytique 5 isolant électriquement les première et seconde couches électriquement conductrices 1, 7 entre les batteries. Autrement dit, dans la pluralité de batteries, chaque batterie comporte deux électrodes qui lui sont exclusivement associées, et la membrane 5 électrolytique forme une unique couche non structurée commune à toutes les batteries. L'avantage de cette membrane 5 commune est de permettre de s'affranchir du dépôt d'une couche isolante supplémentaire jouant le rôle d'isolant électrique entre les première et seconde couches électriquement conductrices 1, 7. En effet, dans ce dernier cas, le rôle d'isolation électrique entre les première et seconde couches électriquement conductrices 1, 7 est assuré par la membrane 5 elle-même qui recouvre comme illustré à la figure 11 les batteries et les espaces entre deux batteries adjacentes.

Selon un autre mode de réalisation, la seconde couche électriquement conductrice 7 est déposée uniquement sur les batteries fonctionnelles 3a, 3b, 3d afin de former un dispositif à batteries comportant les batteries fonctionnelles 3a, 3b, 3d reliées électriquement en parallèle et les batteries défectueuses 3c isolées électriquement des batteries fonctionnelles 3a, 3b, 3d.

Au final, bien que cela ne soit pas représenté sur les figures le dispositif à batteries pourra être encapsulé vis-à-vis de l'atmosphère pour protéger ledit dispositif. Une telle protection peut être formée par un empilement de couches minces, par un laminage, par report d'un capot, etc.

Dans les différents exemples et modes de réalisation, le dispositif peut être réalisé à base de couches minces. La première couche électriquement conductrice peut être réalisée en Al, Pt, Au, Ti, W, Mo. L'une des électrodes dite positive est réalisée en LiTiOS, LiCoO₂, LiNiO₂, LiMn₂O₄, CuS, CuS₂, WO_{y}S_{z}; TiO_{y}S_{z}, V₂O₅ Selon les matériaux choisis pour l'électrode positive, un recuit thermique peut être nécessaire pour augmenter la cristallisation de la couche associée et sa propriété d'insertion des ions, notamment pour les oxydes lithiés, au contraire certains matériaux amorphes comme les oxysulfures de titane ne nécessitent pas un tel traitement pour permettre une insertion élevée d'ions lithium. La membrane électrolytique est préférentiellement un bon conducteur ionique et un isolant électrique, il s'agit en général d'un matériau vitreux à base d'oxyde de bore, d'oxydes de lithium ou de sels de lithium. Les membranes à base de LiPON, LiSiPON ou LiPONB seront préférées pour leurs performances. L'électrode négative peut être du Si, du lithium métallique déposé par évaporation thermique, un alliage métallique de lithium ou un composé d'insertion (SiTON, SnNx, InNx, SnO2, etc.), l'électrode négative peut aussi ne pas être présente, dans ce cas une couche de métal bloquant le lithium est déposée puis le lithium est électro déposé sur cette couche. Généralement, ces couches sont structurées pour délimiter les empilements (à l'exception, le cas échéant, de la couche destinée à former la membrane), on pourra citer à titre d'exemple les techniques de masque mécanique, de photolithographie, de gravure laser. Les méthodes telles que la photolithographie seront préférées car elles permettent d'avoir des précisions importantes avec des faibles traits de gravure pour maximiser la surface active des batteries et donc la capacité maximale du dispositif à batteries.

Selon un exemple particulier de réalisation, la première couche électriquement conductrice est en aluminium, les premières électrodes sont en LiTiOS, les membranes 5 sont en LiPONB, les secondes électrodes sont en Si, la couche intermédiaire 6 est en titane, la seconde couche électriquement conductrice est en aluminium, titane, nickel ou autres matériaux idoines.

Selon une variante non représentée, lorsque qu'une batterie défectueuse est détectée, il s'en suit une étape de gravure localisée retirant tout l'empilement défectueux jusqu'à la première couche électriquement conductrice.
Dans les différents modes de réalisation décrits précédemment, les batteries fonctionnelles 3a, 3b, 3d sont connectées électriquement à la première couche électriquement conductrice 1 et à la seconde couche électriquement conductrice 7, la batterie défectueuse 3c est connectée au plus à l'une des couches électriquement conductrices 1,7. Par exemple, la batterie défectueuse est soit connectée électriquement uniquement à l'une des couches électriquement conductrices 1,7 soit isolée électriquement de la première couche électriquement conductrice 1 et de la seconde couche électriquement conductrice 7.

Les batteries forment des zones actives opaques par construction. En dehors de ces zones actives, le dispositif à batteries sera, de préférence transparent. Pour cela les première et seconde couches électriquement conductrices 1 et 7 seront préférentiellement réalisées en TCO (oxydes conducteurs transparents). Le cas échéant entre deux batteries adjacentes, les première et seconde couches électriquement conductrices 1 et 7 seront séparées par une unique couche électriquement isolante 8 elle aussi transparente. Dans le troisième mode de réalisation où les première et seconde couches électriquement conductrices 1 et 7 sont séparées par une portion de la membrane électrolytique 5 entre deux batteries adjacentes, la membrane électrolytique 5 sera préférentiellement réalisée en verre lithié pour lui conférer des propriétés de transparence. L'utilisation de ce type de matériaux permet de conférer des propriétés de transparence au dispositif final. Par exemple, un ratio de remplissage de 10% de la surface du substrat de support conduit à un facteur de transmittance de l'ordre de 70%. On peut aller jusqu'à un ratio de remplissage de 40%. Dès lors, un compromis peut ainsi être trouvé entre capacité et transmittance. De plus, préférentiellement, les dimensions latérales des empilements seront inférieures à 100µm afin de ne pas être visibles à l'oeil humain. Avantageusement, les batteries sont agencées de sorte à obtenir un taux de remplissage du substrat de support 2 inférieur ou égal à 40% et la surface de chaque batterie est inférieure ou égale à 10⁴ µm². Par surface d'une batterie, on entend la surface occupée par la batterie au niveau du substrat de support 2. Les batteries sont, de préférence, réparties de manière homogène à la surface du substrat, par exemple sous forme d'une matrice comme indiqué précédemment.

L'avantage de la transparence peut être utilisé pour réaliser par exemple une fenêtre active avec électrochrome qui nécessite de l'énergie pour changer de couleur, ou pour l'encapsulation d'une cellule photovoltaïque

Lorsque qu'au moins une batterie est détectée défectueuse, le dispositif à batteries obtenu comporte une pluralité de batteries dont un premier ensemble comporte des batteries fonctionnelles reliées électriquement en parallèle, et dont un second ensemble comporte au moins une batterie défectueuse rattachée uniquement à l'un des collecteurs de courant formé par une des couches électriquement conductrices.

Parmi les applications visées figurent les capteurs autonomes, les cartes à puces, les étiquettes intelligentes, ainsi que tout le domaine de l'électronique souple sur grandes surfaces.

## Revendications

1. Procédé de réalisation d'un dispositif à batteries comprenant les étapes successives suivantes :
- prévoir un substrat de support (2) comportant une première couche électriquement conductrice (1) formant une face principale,
- former simultanément sur la première couche électriquement conductrice (1) une pluralité de batteries (3a 3b, 3c, 3d),
- tester le fonctionnement des batteries (3a, 3b, 3c, 3d), pour discriminer un premier groupe de batteries fonctionnelles (3a, 3b, 3d) et un deuxième groupe de batteries défectueuses (3c),
- former une seconde couche électriquement conductrice (7), isolée électriquement de la première couche électriquement conductrice (1), les batteries fonctionnelles (3a, 3b, 3d) étant connectées électriquement à la première couche électriquement conductrice (1) et à la seconde couche électriquement conductrice (7),
**caractérisé en ce que** la batterie défectueuse (3c) est connectée électriquement au plus à l'une des couches électriquement conductrices (1,7),
de manière à ce que la seconde couche électriquement conductrice (7) et la première couche électriquement conductrice (1) soient configurées pour connecter en parallèle uniquement les batteries fonctionnelles (3a, 3b, 3d).

2. Procédé selon la revendication 1, **caractérisé en ce que** la batterie défectueuse (3c) est isolée électriquement de la première couche électriquement conductrice (1) et de la seconde couche électriquement conductrice (7).

3. Procédé selon la revendication 1, **caractérisé en ce que** la batterie défectueuse (3c) est seulement isolée électriquement de la première couche électriquement conductrice (1).

4. Procédé selon l'une quelconque des revendications 1 à 3, **caractérisé en ce qu'**une portion (1 a) de la première couche électriquement conductrice recouverte par une batterie défectueuse (3c) est isolée électriquement d'une autre portion (1 b) de la première couche électriquement conductrice couplée électriquement aux batteries fonctionnelles (3a, 3b, 3d), avant l'étape de dépôt de la seconde couche électriquement conductrice (7).

5. Procédé selon la revendication 1, **caractérisé en ce que** la batterie défectueuse (3c) est seulement isolée électriquement de la deuxième couche électriquement conductrice (7).

6. Procédé selon l'une des revendications 2 et 5, **caractérisé en ce que** la seconde couche électriquement conductrice (7) est déposée de sorte à être connectée électriquement avec toutes les batteries (3a, 3b, 3c, 3d), ladite seconde couche électriquement conductrice (7) étant structurée pour isoler électriquement une portion (7a) de la seconde couche électriquement conductrice associée à une batterie défectueuse (3c) d'une autre portion (7b) de la seconde couche électriquement conductrice commune aux batteries fonctionnelles (3a, 3b, 3d).

7. Procédé selon l'une des revendications 2 et 5, **caractérisé en ce que** la seconde couche électriquement conductrice (7) est déposée uniquement sur les batteries fonctionnelles (3a, 3b, 3d) afin de former un dispositif à batteries comportant les batteries fonctionnelles (3a, 3b, 3d) reliées électriquement en parallèle et les batteries défectueuses (3c) isolées électriquement des batteries fonctionnelles (3a, 3b, 3d).

8. Procédé selon l'une quelconque des revendications 1 à 7, **caractérisé en ce que** les batteries (3a, 3b, 3c, 3d) sont situées dans un même plan parallèle au substrat de support (2).

9. Procédé selon l'une quelconque des revendications 1 à 8, **caractérisé en ce que** les batteries sont agencées de sorte à obtenir un taux de remplissage du substrat de support (2) inférieur ou égal à 40%, la surface de chaque batterie étant inférieure ou égale à 10⁴ µm².

10. Procédé selon l'une quelconque des revendications 1 à 9, **caractérisé en ce que** l'étape de formation de la pluralité de batteries comporte le dépôt d'une membrane électrolytique (5) commune à toutes les batteries, ladite membrane électrolytique isolant électriquement les première et seconde couches électriquement conductrices (1, 7) entre les batteries.

11. Procédé selon l'une quelconque des revendications 1 à 10, **caractérisé en ce que** chaque batterie (3a, 3b, 3c, 3d) comporte un empilement comprenant une première électrode (4a), une membrane électrolytique (5), une seconde électrode (4b), la première électrode (4a) étant en contact électrique avec la première couche électriquement conductrice (1).

12. Procédé selon la revendication 11, **caractérisé en ce que** l'étape de test est réalisée en prenant, pour chaque batterie (3a, 3b, 3c, 3d), un premier contact électrique (C1) sur la première couche électriquement conductrice (1), et un second contact électrique (C2) associé à la seconde électrode (4b) de la batterie concernée de sorte à réaliser un test électrique de la batterie.

13. Procédé selon l'une quelconque des revendications 1 à 12, **caractérisé en ce qu'**il comporte :
- le dépôt d'une couche électriquement isolante (8) pour recouvrir toutes les batteries (3a, 3b, 3c, 3d),
- l'ouverture localisée de la couche électriquement isolante (8) pour accéder uniquement aux batteries fonctionnelles (3a, 3b, 3d),
- le dépôt de la seconde couche électriquement conductrice (7) pour connecter toutes les batteries fonctionnelles (3a, 3b, 3d) à travers la couche électriquement isolante (8).

## Patentansprüche

1. Verfahren zur Herstellung einer Batterienvorrichtung, welches folgende Verfahrensschritte umfasst:
- es wird ein Trägersubstrat (2) vorgesehen, das eine erste elektrisch leitende Schicht (1) aufweist, die eine Hauptseite bildet,
- auf der ersten elektrisch leitenden Schicht (1) werden gleichzeitig mehrere Batterien (3a, 3b, 3c, 3d) gebildet,
- es wird die Funktionstüchtigkeit der Batterien (3a, 3b, 3c, 3d) getestet, um eine erste Gruppe von funktionsfähigen Batterien (3a, 3b, 3d) und eine zweite Gruppe von defekten Batterien (3c) zu unterscheiden,
- es wird eine zweite elektrisch leitende Schicht (7) gebildet, die von der ersten elektrisch leitenden Schicht (1) elektrisch isoliert ist,
wobei die funktionsfähigen Batterien (3a, 3b, 3d) mit der ersten elektrisch leitenden Schicht (1) und der zweiten elektrisch leitenden Schicht (7) elektrisch verbunden werden,
**dadurch gekennzeichnet,**
**dass** die defekte Batterie (3c) höchstens mit einer der elektrisch leitenden Schichten (1, 7) elektrisch verbunden wird,
so dass die zweite elektrisch leitende Schicht (7) und die erste elektrisch leitende Schicht (1) dergestalt konfiguriert werden, dass sie nur die funktionsfähigen Batterien (3a, 3b, 3d) parallel geschaltet verbinden.

2. Verfahren nach Anspruch 1,
**dadurch gekennzeichnet,**
**dass** die defekte Batterie (3c) von der ersten elektrisch leitenden Schicht (1) und der zweiten elektrisch leitenden Schicht (7) elektrisch isoliert ist.

3. Verfahren nach Anspruch 1,
**dadurch gekennzeichnet,**
**dass** die defekte Batterie (3c) nur von der ersten elektrisch leitenden Schicht (1) elektrisch isoliert ist.

4. Verfahren nach einem der Ansprüche 1 bis 3,
**dadurch gekennzeichnet,**
**dass** ein Abschnitt (1a) der ersten elektrisch leitenden Schicht, der von einer defekten Batterie (3c) bedeckt ist, von einem anderen Abschnitt (1b) der ersten elektrisch leitenden Schicht, der mit den funktionsfähigen Batterien (3a, 3b, 3d) elektrisch gekoppelt ist, vor dem Verfahrensschritt des Auftragens der zweiten elektrisch leitenden Schicht (7) elektrisch isoliert wird.

5. Verfahren nach Anspruch 1,
**dadurch gekennzeichnet,**
**dass** die defekte Batterie (3c) nur von der zweiten elektrisch leitenden Schicht (7) elektrisch isoliert ist.

6. Verfahren nach einem der Ansprüche 2 und 5,
**dadurch gekennzeichnet,**
**dass** die zweite elektrisch leitende Schicht (7) dergestalt aufgetragen wird, dass sie mit allen Batterien (3a, 3b, 3c, 3d) elektrisch verbunden ist, wobei diese zweite elektrisch leitende Schicht (7) dergestalt strukturiert wird, dass sie einen Abschnitt (7a) der zweiten elektrisch leitenden Schicht, der einer defekten Batterie (3c) zugeordnet ist, von einem anderen Abschnitt (7b) der zweiten elektrisch leitenden Schicht, der den funktionsfähigen Batterien (3a, 3b, 3d) gemeinsam ist, elektrisch isoliert.

7. Verfahren nach einem der Ansprüche 2 und 5,
**dadurch gekennzeichnet,**
**dass** die zweite elektrisch leitende Schicht (7) nur auf den funktionsfähigen Batterien (3a, 3b, 3d) aufgetragen wird, um eine Batterienvorrichtung zu bilden, in der die funktionsfähigen Batterien (3a, 3b, 3d) elektrisch parallel miteinander geschaltet sind und die defekten Batterien (3c) von den funktionsfähigen Batterien (3a, 3b, 3d) elektrisch isoliert sind.

8. Verfahren nach einem der Ansprüche 1 bis 7,
**dadurch gekennzeichnet,**
**dass** die Batterien (3a, 3b, 3c, 3d) in einer und derselben Ebene parallel zum Trägersubstrat (2) vorgesehen werden.

9. Verfahren nach einem der Ansprüche 1 bis 8,
**dadurch gekennzeichnet,**
**dass** die Batterien dergestalt angeordnet werden, dass ein Grad des Besetzens des Trägersubstrats (2) von weniger als oder gleich 40 % erreicht wird, wobei die Oberfläche jeder Batterie kleiner als oder gleich 10⁴ µm² ist.

10. Verfahren nach einem der Ansprüche 1 bis 9,
**dadurch gekennzeichnet,**
**dass** der Verfahrensschritt des Bildens mehrerer Batterien das Auftragen einer allen Batterien gemeinsamen elektrolytischen Membran (5) umfasst, wobei diese elektrolytische Membran die erste und die zweite elektrisch leitende Schicht (1, 7) zwischen den Batterien elektrisch voneinander isoliert.

11. Verfahren nach einem der Ansprüche 1 bis 10,
**dadurch gekennzeichnet,**
**dass** jede Batterie (3a, 3b, 3c, 3d) eine Stapelung aufweist, die eine erste Elektrode (4a), eine elektrolytische Membran (5), eine zweite Elektrode (4b) umfasst, wobei die erste Elektrode (4a) in elektrischem Kontakt mit der ersten elektrisch leitenden Schicht (1) ist.

12. Verfahren nach Anspruch 11,
**dadurch gekennzeichnet,**
**dass** der Verfahrensschritt des Testens durchgeführt wird, indem für jede Batterie (3a, 3b, 3c, 3d) ein erster elektrischer Kontakt (C1) an der ersten elektrisch leitenden Schicht (1) und ein zweiter elektrischer Kontakt (C2) an der zweiten Elektrode (4b) der betreffenden Batterie abgenommen wird, um einen elektrischen Test der Batterie durchzuführen.

13. Verfahren nach einem der Ansprüche 1 bis 12,
**dadurch gekennzeichnet,**
**dass** es beinhaltet:
- das Auftragen einer elektrisch isolierenden Schicht (8), um alle Batterien (3a, 3b, 3c, 3d) zu überziehen,
- das stellenweise Öffnen der elektrisch isolierenden Schicht (8), um nur an die funktionsfähigen Batterien (3a, 3b, 3d) zu gelangen,
- das Auftragen der zweiten elektrisch leitenden Schicht (7), um alle funktionsfähigen Batterien (3a, 3b, 3d) durch die elektrisch isolierende Schicht (8) hindurch anzuschließen.

## Claims

1. A method for producing a device having batteries comprising the following successive steps:
- providing a support substrate (2) comprising a first electrically conducting layer (1) forming a main surface,
- simultaneously forming a plurality of batteries (3a 3b, 3c, 3d) on the first electrically conducting layer (1),
- testing operation of the batteries (3a, 3b, 3c, 3d) to discriminate between a first group of functional batteries (3a, 3b, 3d) and a second group of defective batteries (3c),
- forming a second electrically conducting layer (7) electrically insulated from the first electrically conducting layer (1), the functional batteries (3a, 3b, 3d) being electrically connected to the first electrically conducting layer (1) and to the second electrically conducting layer (7),
**characterized in that** the defective battery (3c) is electrically connected at most to one of the electrically conducting layers (1,7) so that the second electrically conducting layer (7) and the first electrically conducting layer (1) be configured to connect only the functional batteries (3a, 3b, 3d) in parallel.

2. The method according to claim 1, **characterized in that** the defective batteries (3c) is electrically insulated from the first electrically conducting layer (1) and from the second electrically conducting layer (7).

3. The method according to claim 1, **characterized in that** the defective batteries (3c) is electrically insulated only from the first electrically conducting layer (1).

4. The method according to any one of claims 1 to 3, **characterized in that** a portion (1a) of the first electrically conducting layer (1) covered by a defective battery (3c) is electrically insulated from another portion (1 b) of the first electrically conducting layer electrically coupled to the functional batteries (3a, 3b, 3d), before depositing the second electrically conducting layer (7).

5. The method according to claim 1, **characterized in that** the defective batteries (3c) is electrically insulated only from the second electrically conducting layer (7).

6. The method according to any one of claims 2 and 5, **characterized in that** the second electrically conducting layer (7) is deposited so as to be electrically connected with all the batteries (3a, 3b, 3c, 3d), said second electrically conducting layer (7) being patterned to electrically insulate a portion (7a) of the second electrically conducting layer associated with a defective battery (3c) of another portion (7b) of the second electrically conducting layer common to the functional batteries (3a, 3b, 3d).

7. The method according to any one of claims 2 and 5, **characterized in that** the second electrically conducting layer (7) is only deposited on the functional batteries (3a, 3b, 3d) so as to form a device having batteries comprising the functional batteries (3a, 3b, 3d) connected in parallel and the defective batteries (3c) electrically insulated from the functional batteries (3a, 3b, 3d).

8. The method according to any one of claims 1 to 7, **characterized in that** the batteries (3a, 3b, 3c, 3d) are situated in one and the same plane parallel to the support substrate (2).

9. The method according to any one of claims 1 to 8, **characterized in that** the batteries are arranged so as to obtain a filling ratio of the support substrate (2) less than or equal to 40%, the surface of each battery being smaller than or equal to 10⁴ µm².

10. The method according to any one of claims 1 to 9, **characterized in that** the step of formation of the plurality of batteries comprises deposition of an electrolytic membrane (5) common to all the batteries, said electrolytic membrane electrically insulating the first and second electrically conducting layers (1, 7) between the batteries.

11. The method according to any one of claims 1 to 10, **characterized in that** each battery (3a, 3b, 3c, 3d) comprises a stack comprising a first electrode (4a), an electrolytic membrane (5), and a second electrode (4b), the first electrode (4a) being in electric contact with the first electrically conducting layer (1).

12. The method according to claim 11, **characterized in that** the testing step is performed by taking, for each battery (3a, 3b, 3c, 3d), a first electric contact (C1) on the first electrically conducting layer (1), and a second electric contact (C2) associated with the second electrode (4b) of the battery concerned so as to perform electric testing of the battery.

13. The method according to any one of claims 1 to 12, **characterized in that** it comprises:
- deposition of an electrically insulating layer (8) to cover all the batteries (3a, 3b, 3c, 3d),
- localized opening of the electrically insulating layer (8) to access the functional batteries (3a, 3b, 3d) only,
- deposition of the second electrically conducting layer (7) to connect all the functional batteries (3a, 3b, 3d) through the electrically insulating layer (8).
